# EUROPEAN PATENT APPLICATION

(11) **EP 1 648 091 A1**
(43) Date of publication of application: **19.04.2006**
(21) Application number: 05022215.7
(22) Date of filing: 12.10.2005
(51) Int. Cl.: H03M 13/11, H04L 1/00, H03M 13/37

(54) **Method and apparatus for efficiently decoding low density parity check code**

(30) Priority: 12.10.2004 KR 2004081417
(71) Applicant: Samsung Electronics Co., Ltd., Suwon-si, Gyeonggi-Do (KR)
(72) Inventor: Park, Sung-Jin, Yeongtong-gu Suwon-si Gyeonggi-do (KR); Kim, Sang-Hyo, Yeongtong-gu Suwon-si Gyeonggi-do (KR); Kim, Han-Ju, Yeongtong-gu Suwon-si Gyeonggi-do (KR); Kim, Min-Goo, Yeongtong-gu Suwon-si Gyeonggi-do (KR)
(74) Representative: Lang, Johannes

(57) **Abstract**

A method and apparatus are provided for decoding a forward error correction code in a mobile communication system using a LDPC code. A check node processor performs check node processing on information received with a plurality of check nodes and an accumulator accumulates check node output values from the check node processor with previous accumulated values. An edge memory stores the check node output values, and two accumulation memories separately store accumulated values from the accumulator and the previous accumulated values. A subtractor subtracts the check node output values from the accumulated values, and a hard-decision decoding block performs hard-decision decoding on the received information and the output value of the subtractor. A bit buffer stores the hard-decision decoding result, and a parity check block performs parity check on the hard-decision decoding result to determine whether to stop iterative decoding. A multiplexer delivers the subtraction result values to both the check node processor and the hard-decision decoding block.

## Description

### BACKGROUND OF THE INVENTION

### Field of the Invention:

The present invention relates generally to an error correction decoding apparatus and method. More particularly, the present invention relates to a decoding apparatus and method for improving decoding performance by reducing decoding complexity of a low density parity check code (LDPC).

### Description of the Related Art:

In general, a digital communication system suffers from errors due to noise generated in a transmission path and corrects the errors with various algorithms to remove the generated errors. In a wireless communication system employing 3^{rd} Generation Partnership Project (3GPP) or 3^{rd} Generation Partnership Project 2 (3GPP2), which is currently under standardization, the use of convolutional codes and turbo codes is proposed for the transmission of voice and control signals. The turbo code for high-speed transmission is advantageous in that it can obtain a very low bit error rate (BER) at a low signal-to-noise ratio (SNR). However, the turbo code is relatively short in the minimum distance between codewords. As a result, when a signal coded with the turbo code is decoded, an error floor may occur at a desired bit error point, and a detection failure probability for defective codewords during the decoding is relatively high. Recently, therefore, new attention has been given to an LDPC which is similar or superior to the turbo code in performance.

The LDPC has greater minimum distance than the turbo code having the same length as that of the LDPC. As a result, the error floor occurs at a very low BER as compared with the turbo code, and the detection failure probability for defective codewords is very low, approximately '0' on an experimental basis. In addition, the LDPC can be implemented in a parallel structure, contributing to a dramatic reduction in decoding time, and can be subject to efficient decoding stop without a decoding stop algorithm or overhead such as cyclic redundancy check (CRC) bits added through parity check performed every iterative decoding.

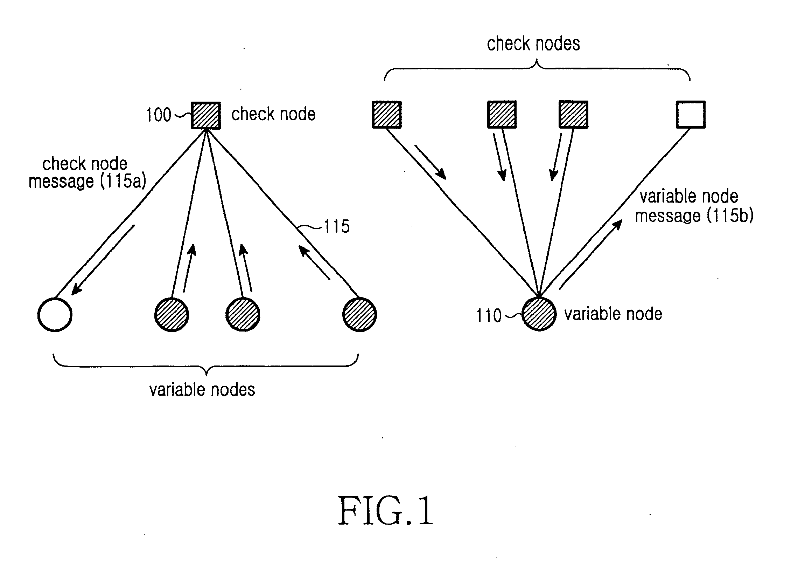

FIG. 1 is a diagram illustrating an LDPC decoding structure.
Referring to FIG. 1, the LDPC is a code having a parity check matrix in which the number of 1s in each row and column is very small, and its structure can be defined by a factor graph including check nodes 100, variable nodes 110, and edges 115 for connecting the check nodes 100 to the variable nodes 110. A value delivered from the check node 100 to the variable node 110 after check node processing becomes a check node message 115a, and a value delivered from the variable node 110 to the check node 100 after variable node processing becomes a variable node message 115b.

A decoding process of the LDPC code is achieved by iterative decoding based on a 'sum-product' algorithm. The optimal sum-product algorithm includes relatively complex calculations. Therefore, the use of the sum-product algorithm requires a large amount of calculations in the decoding process, thereby increasing hardware complexity.

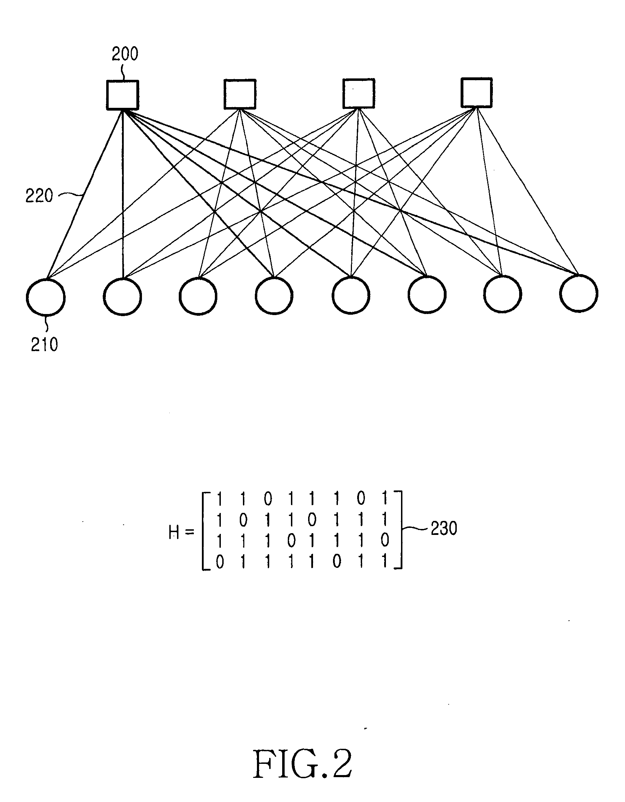

The LDPC will now be described in greater detail with reference to FIG. 2.

FIG. 2 is a diagram illustrating an exemplary structure of an LDPC according to a factor graph and a parity check matrix. Herein, a structure of the LDPC can be defined by the most popular factor graph. The factor graph is a bipartite graph for expressing a multi-variable total function that is factorized into products of local functions.

Referring to FIG. 2, the factor graph of an LDPC has a tree structure expressed through the sum-product algorithm. Specifically, the factor graph determines a structure of four check nodes 200 representing predetermined parity check equations of the LDPC, eight variable nodes 210 representing symbols, and edges 220 representing relationships therebetween. The edges 220 connect each check node 200 to the variable node 210 corresponding to a code symbol included in a parity check equation represented by the check node 200. Herein, an exemplary regular LDPC is shown wherein the number of the variable nodes 210 connected to each of the check nodes 200 is fixed to 6 and the number of the check nodes 200 connected to each of the variable nodes 210 is fixed to 3, but is not limited thereto. Although not illustrated, an irregular LDPC can be provided in which the number of edges connected to each of the check nodes 200 and the variable nodes 210 is not fixed.

A parity check matrix (H) 230 for the parity check code is also shown in FIG. 2, and is similar to the graphic expression of the parity check code. In the parity check matrix 230, the number of 1s in each column and each row is fixed. That is, each column of the parity check matrix 230 has three 1s corresponding to the connections between each of the variable nodes 210 and the check nodes 200, and each row has six 1s corresponding to the connections between each of the check nodes 200 and the variable nodes 210.

A process of decoding the LDPC is achieved by iterating a process of exchanging messages generated and updated for each individual node by the variable nodes and the check nodes in the factor graph. In this case, each node updates the messages using the sum-product algorithm. The iterative decoding process of the LDPC code, based on the foregoing decoding process, will now be described in greater detail below.

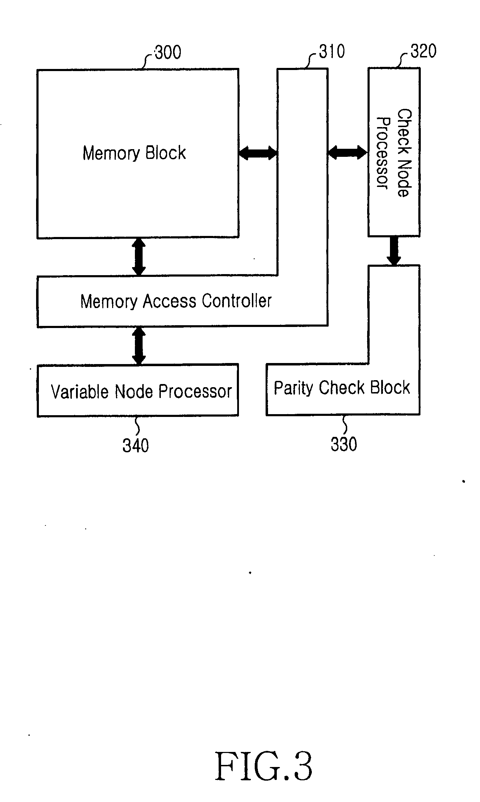

FIG. 3 is a block diagram of a general LDPC.

Referring to FIG. 3, an LDPC decoding apparatus comprises a memory block 300 for storing received information, a variable node processor 340 for performing variable node-related calculation (hereinafter referred to as "variable node processing"), a check node processor 320 for performing check node-related calculations (hereinafter referred to as "check node processing"), a parity check block 330 for determining whether to perform iterative decoding by checking if all errors were corrected in check nodes, and a memory access controller 310 for performing fast, efficient memory access.

A brief description of the LDPC decoding order will now be made herein below.

First, received symbols are stored in the memory block 300 as initial values of the variable nodes.

Second, the check node processor 320 reads variable node values stored in the memory block 300, the parity check block 330 performs parity check on the read variable node values, and the check node processor 320 calculates a transmission path transition probability for 0 and 1 of the read variable node values and over-writes the calculated probability values as variable node values in the memory block 300.

Third, the variable node processor 340 reads the variable node values overwritten in the memory block 300 and calculates a log likelihood ratio (LLR) using the read variable node values.

Fourth, the second and third processes are iterated until the parity check block 330 succeeds in parity check and determines to end the iterative decoding, thereby increasing reliability.

The variable node processor 340 and the check node processor 320 read and calculate values from memory areas corresponding to positions of 1s in the columns and rows of a parity check matrix, respectively, and overwrite the calculated values in the same memory areas.

As described above, a calculation algorithm for separately performing check node processing and variable node processing uses a high-capacity memory. That is, the memory block 300 must store therein information on all of the edges, and the check node processor 320 and the variable node processor 340 each read necessary values from the memory block 300 to perform corresponding calculations and calculate LLR values. In this case, the algorithm performs variable node processing after performing check node processing on all of the edges. As a result, the variable node processor 340 operates in the idle mode while the algorithm performs the check node processing. When the algorithm performs variable node processing, the check node processor 320 also operates in the idle mode. That is, the algorithm must read various types of data from the single memory block, causing a memory access delay.

Accordingly, a need exists for a system and method for improving decoding performance by reducing decoding complexity of a low density parity check code (LDPC).

### SUMMARY OF THE INVENTION

An object of the present invention is to substantially solve at least the above problems and disadvantages and to provide at least the advantages below. Accordingly, an object of the present invention is to provide a decoding algorithm for the efficient implementation of an LDPC decoder, and a decoder structure appropriate therefor.

Another object of the present invention is to provide a memory structure for the efficient implementation of an LDPC decoder, and an efficient decoding algorithm according thereto.

Yet another object of the present invention is to provide a method and apparatus for minimizing memory segmentation in an LDPC decoder, and simultaneously processing check node processing and variable node processing.

According to one aspect of the present invention, an apparatus is provided for decoding a forward error correction code in a mobile communication system using a low density parity check code. The apparatus comprises a check node processor for receiving received information with a plurality of check nodes and performing check node processing on the received information, an accumulator for accumulating check node output values from the check node processor with previous accumulated values, an edge memory for storing the check node output values, and at least two accumulation memories for storing accumulated values from the accumulator and the previous accumulated values. The apparatus further comprises a subtractor for subtracting the check node output values read from the edge memory from the accumulated values provided from the accumulator, a hard-decision block for performing hard-decision on the received information and the output value of the subtractor, a bit buffer for storing the hard-decision result, and a parity check block for performing parity check on the hard-decision result to determine whether to stop iterative decoding. The apparatus further comprises a multiplexer for delivering the subtraction result values from the subtractor to the check node processor for performing iterative decoding and at the same time, delivering the subtraction decision values to the hard-decision block.

According to another aspect of the present invention, a method is provided for decoding a forward error correction code in a mobile communication system using a low density parity check code. The method comprises the steps of receiving received information from a plurality of check nodes row by row and performing check node processing on the received information, accumulating result values of the check node processing with previous accumulated values, storing the result values of the check node processing, and separately storing the accumulated values and the previous accumulated values. The method further comprises the steps of subtracting the result values of the check node processing from the accumulated values, performing hard-decision on the received information and the subtraction result values, storing the hard-decision result values, and performing parity check on the hard-decision result to determine whether to stop iterative decoding. The method further comprises the steps of storing the subtraction result values for iterative decoding and at the same time, delivering the subtraction result values to a hard-decision block.

### BRIEF DESCRIPTION OF THE DRAWINGS

The above and other objects, features and advantages of the present invention will become more apparent from the following detailed description when taken in conjunction with the accompanying drawings, in which:
FIG. 1 is a diagram illustrating an exemplary LDPC decoding structure;
FIG. 2 is a diagram illustrating an exemplary factor graph and parity check matrix;
FIG. 3 is a block diagram of an exemplary LDPC;
FIG. 4 is a diagram illustrating a decoding process according to conventional memory segmentation;
FIG. 5 is a flowchart of a conventional decoding algorithm;
FIG. 6 is a diagram illustrating a memory configuration according to an embodiment of the present invention;
FIG. 7 is a diagram illustrating a structure of an LDPC decoder according to an embodiment of the present invention;
FIG. 8 is a conceptual diagram illustrating a decoding algorithm according to an embodiment of the present invention; and
FIG. 9 is a flowchart of a decoding algorithm according to an embodiment of the present invention.

Throughout the drawings, like reference numerals will be understood to refer to like parts, components and structures.

### DETAILED DESCRIPTION OF EXEMPLARY EMBODIMENTS

Exemplary embodiments of the present invention will now be described in detail with reference to the annexed drawings. In the drawings, the same or similar elements are denoted by the same reference numerals even though they are depicted in different drawings. In the following description, a detailed description of known functions and configurations incorporated herein has been omitted for clarity and conciseness.

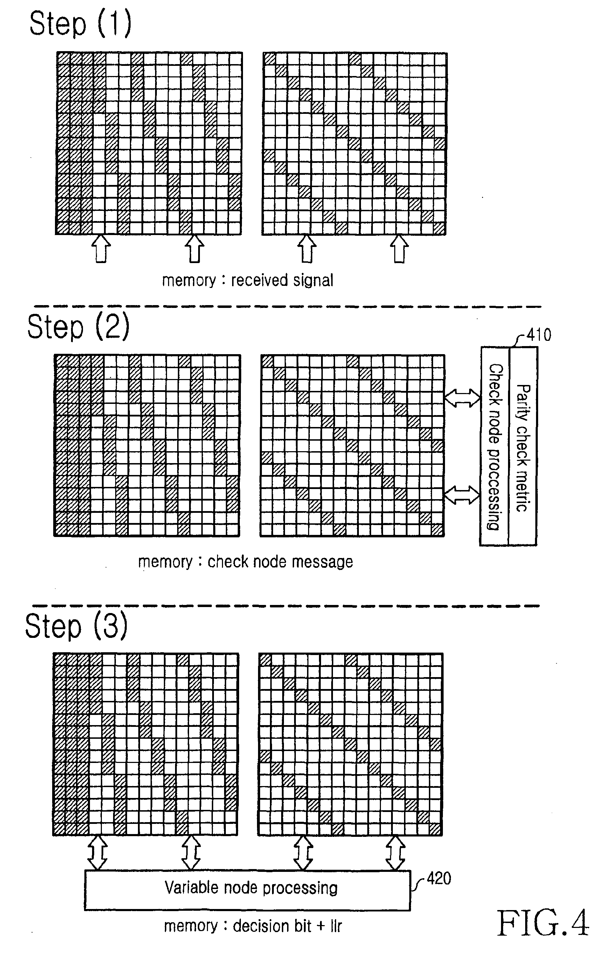

FIG. 4 is a diagram illustrating memory segmentation according to a general decoding process.

Referring to FIG. 4, a memory is provided for a parity check matrix and an identity matrix, respectively, and the memories are each segmented into as many sub-metric blocks as the number of nodes (such as check node processors and variable node processors). That is, the rows of the memories are connected in parallel to check nodes, and sub-metric blocks segmented from the columns of the memories are connected in parallel to variable nodes. Each of the small shaded blocks represents a sub-metric block in which a received signal '1' is stored.

In Step 1, received information is input to sub-metric blocks of each memory.

In Step 2, a check node processing block 410 performs check node processing and parity check on each of the values of the sub-metric blocks segmented from each column, and thereafter, stores the result values of the check node processing back in the sub-metric blocks thereby updating a check node message.

In Step 3, a variable node processing block 420 reads the values updated in the sub-metric blocks of each row, performs variable node processing on the read values, performs hard-decision and LLR calculations, and thereafter, stores the result values back in the sub-metric blocks thereby updating a variable node message. A size of the sub-metric blocks of the memories is determined according to the number of variable node and check node processors. Therefore, an increase in the number of the variable node and check node processors increases the number of the sub-metric blocks segmented from the memories, causing an increase in hardware complexity. However, a decrease in the number of the variable node and check node processors decreases the number of the sub-metric blocks segmented from the memories, causing a reduction in memory access speed and throughput.

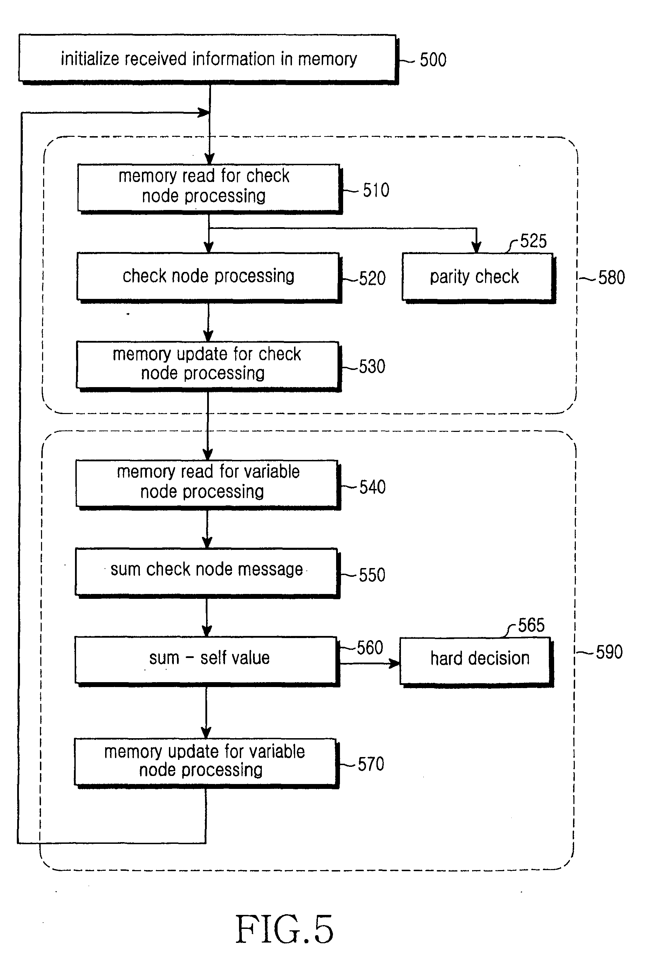

FIG. 5 is a flowchart of a general LDPC decoding algorithm.

Referring to FIG. 5, a check node processing process 580 and a variable node processing process 590 are connected on a cyclic basis, and one calculation process is performed after another calculation process is completed. The two calculation processes are iterated until the algorithm succeeds in parity check.

In step 500, a check node processor reads received information and stores the read information in a memory. This process is called "initialization of LDPC decoding".

The check node processor reads information bits stored in sub-metric blocks of the memory in step 510, and performs check node processing in step 520 while checking parity of the information bits in step 525. If the parity check result is 'good', the check node processor stops the iteration (iterative decoding). Otherwise, the check node processor updates a variable node value in the memory using the check node processing result value in step 530, thereby updating a check node message. After performing the check node message update process, the variable node processing process 590 is initialized.

In step 540, a variable node processor reads variable node values updated according to the check node message, from sub-metric blocks of the memory. The variable node processor sums the updated variable node values in step 550, subtracts variable node values of a corresponding row from the summation result value in step 560, and performs hard-decision on the subtraction result values in step 565. In step 570, the variable node processor stores the subtraction result values in the sub-metric blocks of the memory as variable node values, and then returns to step 510.

As described above, the general LDPC decoding algorithm performs variable node processing after performing check node processing on all of the information bits. Compared with such a general algorithm, the algorithm according to embodiments of the present invention described herein implements check node processing and variable node processing in parallel using only the check node processors and excluding the variable node processors, thereby increasing the throughput.

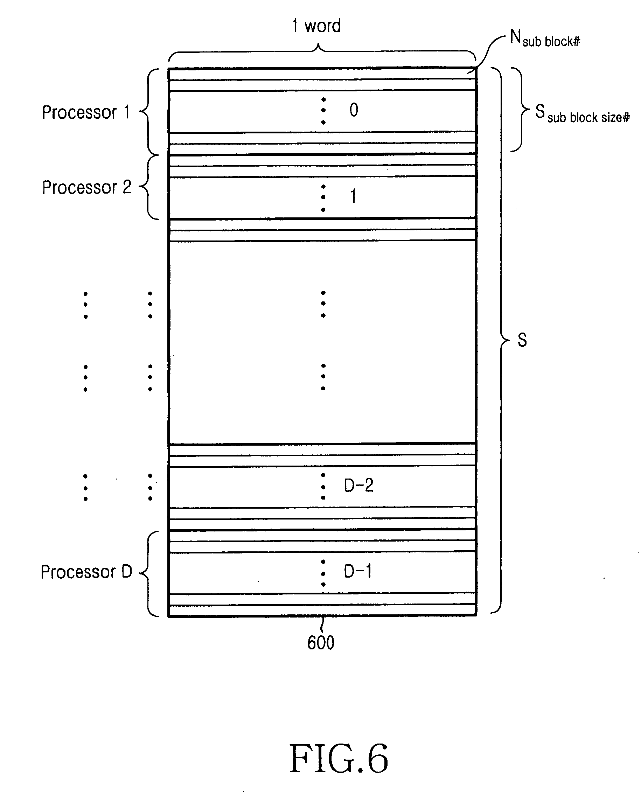

FIG. 6 is a diagram illustrating a memory configuration according to an embodiment of the present invention.

Referring to FIG. 6, a memory 600 is segmented into as many sub-metric blocks as the number (D) of check node processors, so that the sub-metric blocks can be mapped to the check node processors on a one-to-one basis. A size (S_{sub_metric}) of the sub-metric blocks is determined according to the number of 1s existing in each row of a parity check matrix defined by the designer.

Specifically, input information to the memory 600 is divided into as many per-row information pieces as the number D of the sub-metric blocks, that is, the number D of the check node processors. Herein, the per-row information of the input information is called a "one word." A number (N_{sub_block#}) denotes the number of check nodes mapped to one sub-metric block, and is equal to the number of 1s stored in one row. A size (S_{sub_block_size#}) denotes a size of the sub-metric blocks, and is equal to the number of 1s stored in the check nodes of their associated sub-metric blocks.

As the data input to the sub-metric blocks is farmed as words, the input data to the memory 600 has a relatively broad bitwidth. Thus, the information is simultaneously input to the check nodes mapped to the sub-metric blocks, and output values of check nodes are input back to the memory 600, thereby substantially guaranteeing parallelism for the check nodes.

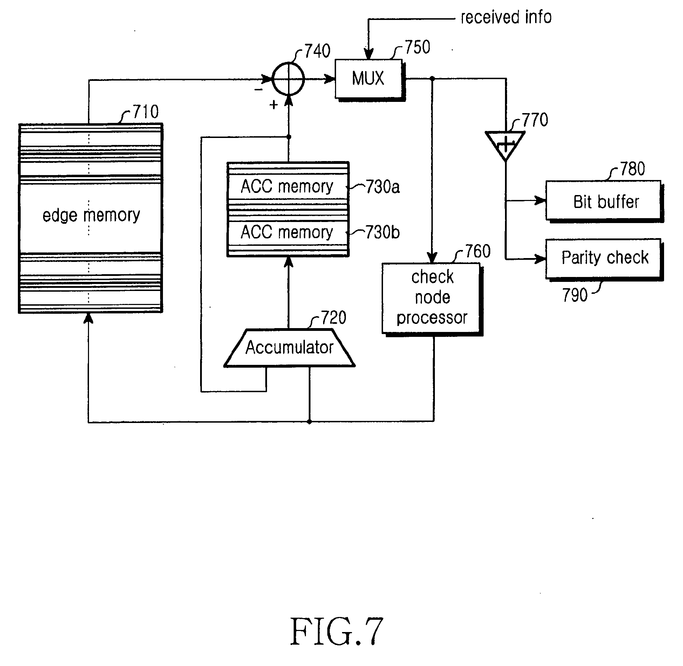

FIG. 7 is a diagram illustrating a structure of an LDPC decoder according to an embodiment of the present invention.

Referring to FIG. 7, an LDPC decoder comprises an edge memory 710 mapped to check nodes of a check node processor 760, and two accumulation (ACC) memories 730a and 730b. The edge memory 710 preferably does not have a separate memory space for storing separate hard-decision values, and preferably has the memory structure shown in FIG. 6. A decoding result of a hard-decision block 770 is stored in a bit buffer 780.

The check node processor 760 performs check node processing on per-row information received from each sub-metric block in a reception buffer for storing received information, and then updates check node values in the edge memory 710 using the result values of the check node processing.

The values output from the check node processor 760 are added to previous check node values stored in the first accumulation memory 730a by an accumulator 720, and then stored in the second accumulation memory 730b. That is, the first accumulation memory 730a stores previous check node values before performing the current check node processing, and the second accumulation memory 730b stores the values accumulated by adding the current check node values to the previous check node values in the first accumulation memory 730a.

A subtractor 740 subtracts memory values of the corresponding sub-metric blocks among the values stored in the edge memory 710 from the accumulated values in the second accumulation memory 730b, and provides the subtraction result to both the check node processor 760 and the hard-decision block 770 via a multiplexer (MUX) 750. The hard-decision block 770 selects one of 0 and 1 by performing hard-decision using the subtraction result.

The bit buffer 780 stores the hard-decision values from the hard-decision block 770, and a parity check block 790 performs parity check on the hard-decision values. If the parity check result of the parity check block 790 is 'good', the LDPC decoder stops the iteration and outputs the hard-decision values in the bit buffer 780 as a decoding result. However, if the parity check result is 'bad', the LDPC decoder reads received information in the next sub-metric block of the reception buffer.

As shown in FIG. 7, the LDPC decoder according to embodiments of the present invention uses two accumulation memories 730a and 703b in order to store both the previous-iteration check node values and the summation values generated by accumulating the check node values up to the current iteration for each sub-metric block, and uses no variable node processor. The variable node processor used in the conventional LDPC decoder is similar in size to the check node processor. Therefore, the LDPC decoder according to embodiments of the present invention increases in memory capacity, but decreases in memory segmentation due to the variable nodes and uses no variable node processor, thereby reducing its complexity due to increases in memory input/output ports and increasing the throughput.

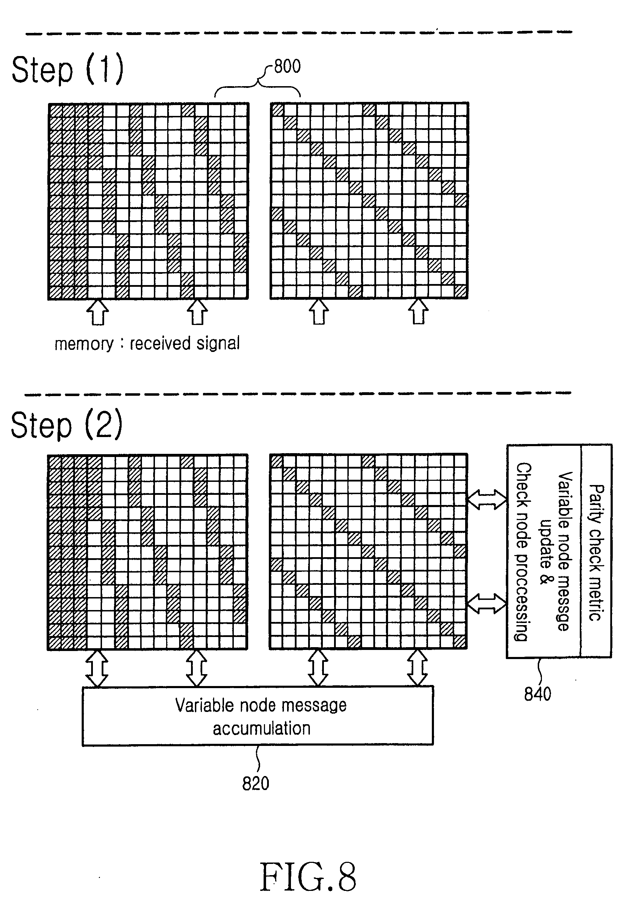

The decoding algorithm according to embodiments of the present invention will now be described with reference to FIGs. 4 and 8.

FIG. 8 is a conceptual diagram illustrating a decoding algorithm according to an embodiment of the present invention.

Compared with the conventional decoding algorithm that must sequentially perform Step 2 and Step 3 of FIG. 4 to perform one iteration, the decoding algorithm according to an embodiment of the present invention performs decoding with only Step 2 of FIG. 8.

Specifically, referring to FIG. 8, each row in a memory 800 is segmented into as many sub-metric blocks as the number of check node processors, and each of the small shaded blocks stores a value '1' in received information.

In Step 1, received information is input to each of the sub-metric blocks in the memory 800 row by row.

In Step 2, at block 840 the decoding algorithm reads memory values in the sub-metric blocks and performs check node processing and parity check on the read memory values. At block 820, the result values of the check node processing are accumulated to the memory values in the sub-metric blocks. The decoding algorithm subtracts the result values of the check node processing from the accumulated values, thereby calculating variable node values. The variable node values are stored back in the sub-metric blocks as memory values. After performing parity check on the variable node values, if the parity check result is 'good', the decoding algorithm stops the iteration. However, if the parity check result is 'bad', the decoding algorithm continues the iteration.

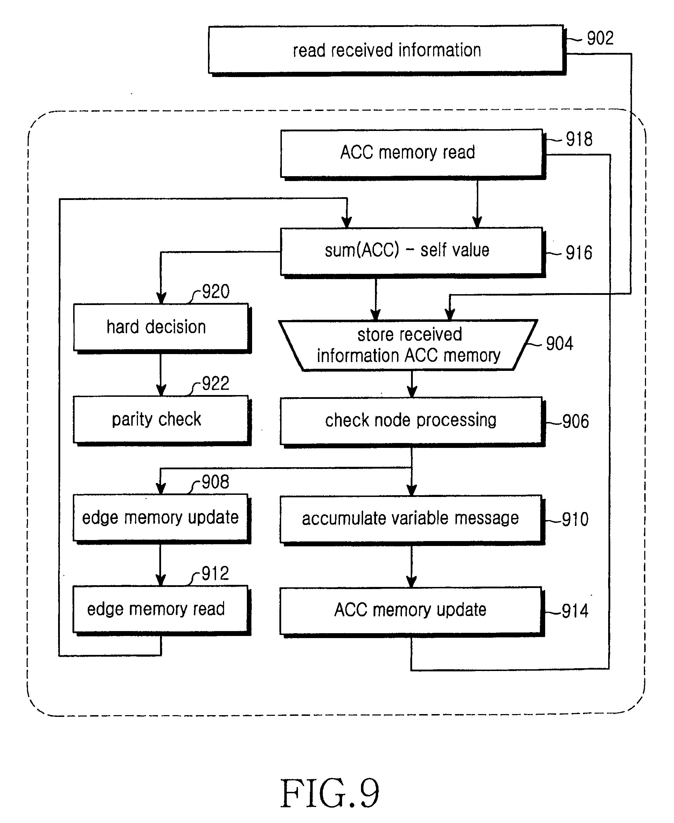

FIG. 9 is a flowchart of a novel decoding algorithm according to an embodiment of the present invention.

Referring to FIG. 9, in step 902, an LDPC decoder reads received information from sub-metric blocks in a reception buffer. The read received information is stored in an accumulation memory in step 904, and is subject to check node processing in step 906, thereby generating check node output values. Memory values in an edge memory are updated with the check node output values in step 908, and at substantially the same time, the check node output values are accumulated with the previous-iteration check node output values in step 910, generating variable node messages. In step 914, the generated variable node messages are used to update accumulated values in their associated sub-metric blocks.

Upon completion of the check node processing on the entire received data, the decoder stops the accumulation of the check node output values. Thereafter, for the next iteration, the decoder reads the updated accumulated values from the sub-metric blocks in step 918, and reads the updated edge memory values, that is, the updated check node output values, in step 912. In step 916, the decoder subtracts the updated check node output values in the edge memory from the updated check node output values accumulated in the accumulation memory. The decoder performs hard-decision and parity check on the subtraction result values, that is, the check node input values, in steps 920 and 922, respectively. If the parity check result is 'good', the decoder stops the iteration and outputs the hard-decision values.

In steps 906 through 910, the check nodes and the accumulator receive the input values on a parallel basis, contributing to the simplification of a memory access process.

As can be understood from the foregoing description, the present invention improves the inefficient memory segmentation and decoding algorithm for an LDPC, and simultaneously performs check node processing and variable node processing, thereby improving throughput. In addition, the present invention contributes to a reduction in hardware complexity through simple memory segmentation and simplification of node processors.

While the invention has been shown and described with reference to a certain exemplary embodiments thereof, it will be understood by those skilled in the art that various changes in form and detail may be made therein without departing from the spirit and scope of the invention as defined by the appended claims.

## Claims

1. An apparatus for decoding a forward error correction code in a mobile communication system using a low density parity check code, the apparatus comprising:
a check node processor for receiving received information with a plurality of check nodes and performing check node processing on the received information;
an accumulator for accumulating check node output values from the check node processor with previous accumulated values;
an edge memory for storing check node output values;
a plurality of accumulation memories for storing accumulated values from the accumulator and the previous accumulated values;
a subtractor for subtracting the check node output values read from the edge memory, from the accumulated values provided from the accumulator;
a hard-decision block for performing hard-decision on the received information and the output value of the subtractor;
a bit buffer for storing the hard-decision result;
a parity check block for performing parity check on the hard-decision result to determine whether to stop iterative decoding; and
a multiplexer for delivering the subtraction result values from the subtractor to the check node processor for iterative decoding and at substantially the same time, delivering the subtraction result values to the hard-decision block.

2. The apparatus of claim 1, wherein if the parity check result is good, the parity check block is configured to stop the iterative decoding and output the hard-decision result.

3. The apparatus of claim 1, wherein the edge memory is segmented into sub-metric blocks being independently mapped to a plurality of check node processors.

4. The apparatus of claim 3, wherein the segmented sub-metric blocks are mapped to the plurality of check nodes and are configured to store at least one of the received information and the check node output values.

5. The apparatus of claim 4, wherein the received information is divided into word units that correspond to the number of the sub-metric blocks.

6. A method for decoding a forward error correction code in a mobile communication system using a low density parity check code, the method comprising the steps of:
receiving received information from a plurality of check nodes row by row and performing check node processing on the received information;
accumulating result values of the check node processing with previous accumulated values;
storing the result values of the check node processing;
separately storing the accumulated values and the previous accumulated values;
subtracting the result values of the check node processing from the accumulated values;
performing hard-decision on the received information and the subtraction result values;
storing the hard-decision result and performing parity check on the hard-decision result to determine whether to stop iterative decoding; and
storing the subtraction result values for iterative decoding and at substantially the same time, delivering the subtraction result values to a hard-decision block.

7. The method of claim 6, wherein the determining step comprises the steps of:
determining whether the parity check result is good; and
if the parity check result is good, stopping the iterative decoding and outputting the hard-decision result.

8. The method of claim 6, wherein the result values of the check node processing are stored in sub-metric blocks being independently mapped to the plurality of check nodes.

9. The method of claim 8, wherein the received information is divided into word units that correspond to the number of the sub-metric blocks.

10. A computer program embodied on a computer-readable medium for decoding a forward error correction code in a mobile communication system using a low density parity check code, comprising:
a first set of instructions for receiving information from a plurality of check nodes row by row and performing check node processing on the received information;
a second set of instructions for accumulating result values of the check node processing with previous accumulated values;
a third set of instructions for storing the result values of the check node processing and separately storing the accumulated values and the previous accumulated values;
a fourth set of instructions for subtracting the result values of the check node processing from the accumulated values and performing hard-decision on the received information and the subtraction result values;
a fifth set of instructions for storing the hard-decision result and performing parity check on the hard-decision result to determine whether to stop iterative decoding; and
a sixth set of instructions for storing the subtraction result values for iterative decoding and at substantially the same time, delivering the subtraction result values to a hard-decision block.
